# EUROPEAN PATENT APPLICATION

(11) **EP 3 407 398 A1**
(43) Date of publication of application: **28.11.2018**
(21) Application number: 16886503.8
(22) Date of filing: 16.12.2016
(51) Int. Cl.: H01L 35/30, F01N 5/02, H02N 11/00, F01N 3/02

(54) **THERMOELECTRIC POWER GENERATION DEVICE**

(30) Priority: 21.01.2016 JP 2016010072; 30.11.2016 JP 2016232201
(71) Applicant: DENSO CORPORATION, Kariya-city, Aichi 448-8661 (JP)
(72) Inventor: KITAGAWA Shinya, Kariya-city Aichi-pref., 448-8661 (JP); OKAMOTO Yoshiyuki, Kariya-city Aichi-pref., 448-8661 (JP)
(74) Representative: TBK
(86) International application number: PCT/JP2016/087504
(87) International publication number: WO 2017/126264

(57) **Abstract**

A thermoelectric power generator includes a pipe (7) in which a first fluid flows, and a power generation module (1) including a thermoelectric conversion element (2). The thermoelectric power generator includes a holding member (3, 4) that is in contact with a one side part of the power generation module, such that heat of a second fluid that is higher in temperature than the first fluid transfers to the one side part of the power generation module. The holding member holds the power generation module and the pipe in a heat transferable state, such that the pipe is in contact with the other side part of the power generation module. The thermoelectric power generator includes a heat conductive component (6) interposed between the holding member and the pipe to define a heat transfer course through which heat transfers from the second fluid to the first fluid, at upstream of the thermoelectric conversion element in a flowing direction of the second fluid.

## Description

### CROSS REFERENCE TO RELATED APPLICATION

This application is based on Japanese Patent Application No. 2016-10072 filed on January 21, 2016, and Japanese Patent Application No. 2016-232201 filed on November 30, 2016, the disclosures of which are incorporated herein by reference.

### TECHNICAL FIELD

The present disclosure relates to a thermoelectric power generator which transforms thermal energy into electric power energy by the Seebeck effect.

### BACKGROUND ART

Patent Literature 1 describes a system effectively using exhaust heat. The system includes a bypass channel in which the exhaust gas flows, a thermoelectric conversion element attached to the exterior of an exhaust pipe, a first exhaust gas passage through which the exhaust gas passes to heat cooling water, and a first valve that opens and closes the first exhaust gas passage. The system further includes a second exhaust gas passage located between the inner circumference side of the exhaust pipe and the outer circumference side of the bypass channel, and a second valve arranged at the downstream end of the bypass channel to open and close the bypass channel.

In the system, when a vehicle is driving with excessive load, the first valve closes the first exhaust gas passage, and the second valve opens the bypass channel. A small amount of the exhaust gas flows in the second exhaust gas passage, and most of the exhaust gas flows in the bypass channel. Thus, most of the exhaust gas flows into the bypass channel, and bypasses the thermoelectric conversion element.

### PRIOR ART LITERATURES

### PATENT LITERATURE

Patent Literature 1 : JP 2015-57547 A

### SUMMARY OF INVENTION

As mentioned above, in Patent Literature 1, the valve is provided to limit the using of heat from high-temperature fluid, so as to restrict deterioration of the thermoelectric conversion element. However, if the using of heat from high-temperature fluid is restricted, the heat recovery performance and the power generation performance will fall, since the using of exhaust heat becomes insufficient at the high load time.

It is an object of the present disclosure to provide a thermoelectric power generator having high performance in both of the heat recovery and the power generation while deterioration of the thermoelectric conversion element caused by heat can be restricted.

Technical means different from each other are used to attain each purpose of embodiments, in the present disclosure. Marks in parenthesis in the claims represent examples to show correspondence relation with the concrete means of the embodiments, and do not limit the technical scope.

According to an aspect of the present disclosure, a thermoelectric power generator includes: a pipe in which a first fluid flows; a power generation module including a thermoelectric conversion element; a holding member that is in direct or indirect contact with a one side part of the power generation module, such that heat of a second fluid that is higher in temperature than the first fluid transfers to the one side part of the power generation module, the holding member holding the power generation module and the pipe in a heat transferable state, such that the pipe is in direct or indirect contact with the other side part of the power generation module; and a heat conductive component that is thermally conductive to define a heat transfer course between the holding member and the pipe, through which heat transfers from the second fluid to the first fluid. The heat conductive component is interposed between the holding member and the pipe, at an upstream side of the thermoelectric conversion element in a flowing direction of the second fluid.

According to the thermoelectric power generator, since the heat conductive component defines the heat transfer course at upstream of the power generation module in the flow of the second fluid, the heat of the second fluid can be transferred to the pipe through the heat conductive component before being transferred to the power generation module through the holding member. Thereby, the temperature of the second fluid can be lowered when heat is transferred to the power generation module, compared with a case where the heat of the second fluid is firstly transferred to the power generation module. Thus, the thermoelectric conversion element can be restricted from being deteriorated, by the lowering in the temperature of the second fluid. Further, since the heat of the second fluid can be recovered to the first fluid through the heat conductive component at the upstream side, the heat recovery performance can be secured. Moreover, the power generation performance can be secured by securing a difference in temperature between the one side part and the other side part of the power generation module, since the amount of heat recovery through the heat conductive component at the upstream side is set properly. Therefore, the heat recovery performance and the power generation performance are both high in the thermoelectric power generator while thermal deterioration of the thermoelectric conversion element can be restricted.

### BRIEF DESCRIPTION OF DRAWINGS

FIG. 1 is a perspective view illustrating a part of a thermoelectric power generator according to a first embodiment.
FIG. 2 is a perspective view illustrating the thermoelectric power generator.
FIG. 3 is a plan view illustrating the thermoelectric power generator seen in an arrow direction III of FIG. 2.
FIG. 4 is a side view illustrating the thermoelectric power generator seen in an arrow direction IV of FIG. 3.
FIG. 5 is an enlarged view illustrating a heat conductive component located upstream of a power generation module in a flow of high-temperature fluid.
FIG. 6 is a graph for explaining a relation between a temperature and a position in a flowing direction of high-temperature fluid, in the thermoelectric power generator.
FIG. 7 is a sectional view illustrating a heat conductive component according to a second embodiment.
FIG. 8 is a perspective view illustrating a part of a thermoelectric power generator according to a third embodiment.
FIG. 9 is an enlarged view illustrating a heat conductive component and a joint part.

### DESCRIPTION OF EMBODIMENTS

Embodiments of the present disclosure will be described hereafter referring to drawings. In the embodiments, a part that corresponds to a matter described in a preceding embodiment may be assigned with the same reference numeral, and redundant explanation for the part may be omitted. When only a part of a configuration is described in an embodiment, another preceding embodiment may be applied to the other parts of the configuration. The parts may be combined even if it is not explicitly described that the parts can be combined. The embodiments may be partially combined even if it is not explicitly described that the embodiments can be combined, provided there is no harm in the combination.

### (First embodiment)

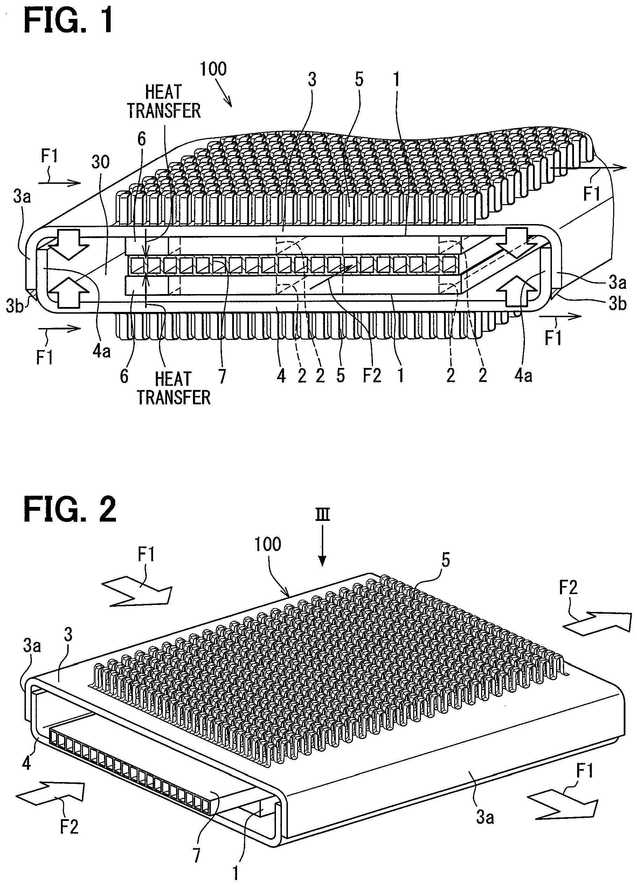

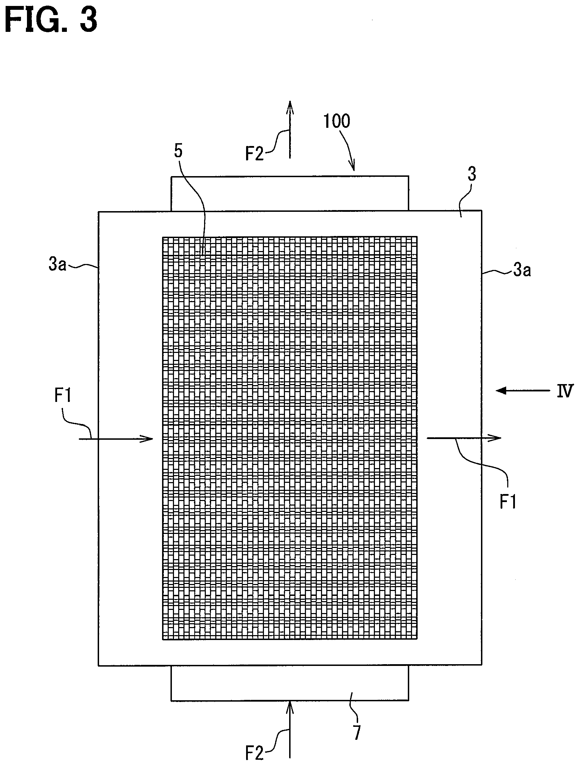

A thermoelectric power generator 100 of a first embodiment is described with reference to FIG. 1 - FIG. 6. The thermoelectric power generator 100 is an equipment which can transform thermal energy into electric power energy by the Seebeck effect. When a difference in temperature is generated between one side and the other side in a power generation module having a thermoelectric conversion element, the thermoelectric power generator 100 generates electric power using phenomenon in which electrons flow due to potential difference. The difference in temperature is generated between the one side and the other side of the power generation module using a first fluid having low temperature and a second fluid having high temperature higher than the first fluid in the thermoelectric power generator 100. The first fluid and the second fluid are selected to provide the difference in temperature. In this embodiment, for example, the cooling water of an engine for a vehicle is used as the first fluid, and exhaust gas exhausted from the engine is used as the second fluid. Hereafter, the first fluid may be referred as low-temperature fluid and the second fluid may be referred as high-temperature fluid higher in temperature than the low-temperature fluid.

The thermoelectric power generator 100 has a first passage through which the high-temperature fluid flows, a second passage through which the low-temperature fluid flows, a power generation module 1, and a heat conductive component 6. Heat is transferable between one side of the power generation module 1 and the high-temperature fluid, and is transferable between the other side of the power generation module 1 and the low-temperature fluid. The heat conductive component 6 facilitates the heat exchange between each fluid and the power generation module 1. The thermoelectric power generator 100 further has a first holding member 3 and a second holding member 4 to raise the tightness between the components for securing heat transfer between the low-temperature fluid and the power generation module 1 and between the high-temperature fluid and the power generation module 1. The first holding member 3 and the second holding member 4 are also called as a holding member 3, 4 below.

The heat conductive component 6 is made of a material by which heat conduction is possible by itself. The heat conductive component 6 is made of a thermally conductive material, for example, metal such as aluminum or copper, graphite, or resin including a thermally conductive material. The heat conduction performance of the heat conductive component 6 may preferably be higher than the heat conduction performance of the power generation module 1.

The heat conductive component 6 may have a board shape, a solid block shape, or a flat rectangular parallelepiped shape. The heat conductive component 6 may be preferably formed to able to be in tight contact between the first holding member 3 and the pipe 7, and between the second holding member 4 and the pipe 7. The heat conductive component 6 may preferably have a volume and an outer shape similar to the power generation module 1. The heat conductive component 6 may preferably have a thickness similar to the power generation module 1.

Each power generation module 1 has the thermoelectric conversion elements 2 stored inside a case having a flat box shape. As shown in FIG. 1, the thermoelectric conversion elements 2 are housed in the power generation module 1 and arranged in the flowing direction F1 of the high-temperature fluid. For preventing the oxidation of the thermoelectric conversion elements 2, for example, the inside of the case is in vacuumed state or is filled with inactive gas. The internal space of the case is air-tightly sealed. The case is made of, for example, stainless steel material.

The thermoelectric conversion element 2 includes P type semiconductor device and N type semiconductor device alternately arranged and connected with each other like mesh. The power generation module 1 has the one side in contact with the high-temperature fluid or a high temperature section which is able to transfer heat with the high-temperature fluid, and the other side in contact with the low-temperature fluid or a low temperature section which is able to transfer heat with the low-temperature fluid. A difference in temperature arises between the one side and the other side of the thermoelectric conversion element 2, and electric power is generated by electrons moved by the potential difference.

The one side of the power generation module 1 located on one side in the thermoelectric power generator 100 is in contact with the first holding member 3 that corresponds to the high temperature section, and the other side is in contact with the pipe 7 that corresponds to the low temperature section. The one side of the power generation module 1 located on the other side in the thermoelectric power generator 100 is in contact with the pipe 7 which corresponds to the low temperature section, and the other side is in contact with the second holding member 4 that corresponds to the high temperature section. Each of the holding members 3 and 4 may be formed by a plate-shape member. The first holding member 3 may be in contact with the one side of the power generation module 1 indirectly through another component. The second holding member 4 may be in contact with the one side of the power generation module 1 indirectly through another component.

The end of the first holding member 3 and the end of the second holding member 4 are shaped to be welded to each other, for example, formed by casting or bending. The first holding member 3 has a joint part 3a defined at the both ends located on the tip side than the bent part which is angled with approximately right angle. The second holding member 4 has a joint part 4a defined at the both ends located on the tip side than the bent part which is angled with approximately right angle. The joint part 3a and the joint part 4a overlap with each other to form an overlap part extending in a direction parallel to the flowing direction F2 of the low-temperature fluid which flows in the pipe 7. At this overlap part, the joint part 3a and the joint part 4a are welded with each other by, for example, seam welding or laser welding. The pipe 7 is held between the two power generation modules 1 and between the two heat conductive components 6 by the compressive force provided from the first holding member 3 and the second holding member 4. The compressive force is a power acting in directions shown in blank arrows in FIG. 1.

The two heat conductive components 6 are held to support the pipe 7 therebetween at the upstream of the two power generation modules 1 in the flowing direction F1 of the high-temperature fluid. Thus, the two heat conductive components 6 are positioned at the most upstream in the entire flow of the high-temperature fluid, in which heat is transferred from the high-temperature fluid to the low-temperature fluid. Each of the heat conductive components 6 is positioned at the most upstream in the range where the heat transfer is performed between the first passage and the second passage. Each heat conductive component 6 defines a heat transfer course which thermally connects the first passage and the second passage at the most upstream in the flow of the high-temperature fluid. The heat conductive component 6 has the same length as the power generation module 1 in the flowing direction F2, and is positioned upstream of the thermoelectric conversion element 2 in the flow of the high-temperature fluid.

The heat conductive component 6 is held by the compressive force, and has no fixing structure fixed to each of the pipe 7, the first holding member 3, and the second holding member 4. That is, the heat conductive component 6 is able to be displaced in the flowing direction F1 of the high-temperature fluid, relative to the pipe 7, the first holding member 3, and the second holding member 4, according to an expansion and a contraction of each component. Therefore, if each component expands and contracts by a difference in temperature caused by the high-temperature fluid and the low-temperature fluid, since the heat conductive component 6 can be displaced, stress caused by distortion of each component can be reduced, and a thermal expansion difference between components can be absorbed.

The interior space 30 is formed between the first holding member 3 and the second holding member 4 joined with each other by welding, as a space surrounded by the first holding member 3 and the second holding member 4. The two power generation modules 1 and the pipe 7 are stored in the interior space 30.

The pipe 7 is made of, for example, stainless steel or aluminum, and includes the second passage divided into plural internal passages through which the low-temperature fluid flows inside. Outer fins 5 are formed on the surface of the first holding member 3 opposite from the power generation module 1. Outer fins 5 are formed on the surface of the second holding member 4 opposite from the power generation module 1. The outer fins 5 are located in the first passage through which the high-temperature fluid flows, and the high-temperature fluid is in contact with the outer fins 5.

The thermoelectric power generator 100 of the first embodiment includes the pipe 7 and the two power generation modules 1. The pipe 7 is interposed between the two power generation modules 1. The pipe 7 has flat external surfaces on the back and the front, and the low-temperature fluid flows inside the pipe 7. The power generation module 1 includes the thermoelectric conversion element 2, and is in contact with the external surface of the pipe 7. The first holding member 3 made of an iron plate or a stainless plate is in contact with a surface of one power generation module 1 located opposite from the pipe 7. The second holding member 4 made of an iron plate or a stainless plate is in contact with a surface of the other power generation module 1 located opposite from the pipe 7. The outer fin 5 made from stainless steel or aluminum is joined by brazing to the surface of the first holding member 3 located opposite from the power generation module 1. The outer fin 5 made from stainless steel or aluminum is joined by brazing to the surface of the second holding member 4 located opposite from the power generation module 1.

The outer fin 5 is formed by bending a plate material to have wave shape. The rigidity of the outer fin 5 is low in the wave advancing direction, and is high in the wave overlapping direction. The rigidity of the first holding member 3 can be raised by brazing the outer fin 5 on the first holding member 3. As a result, a gap which restricts heat transfer is hardly generated between the first holding member 3 and the power generation module 1 and between the second holding member 4 and the power generation module 1. Further, a gap which restricts heat transfer is hardly generated between the first holding member 3 and the heat conductive component 6 and between the second holding member 4 and the heat conductive component 6.

A heat conductive component such as a graphite sheet or grease which has thermal conductivity may be placed at the contact part where the gap may be generated. Some vertical intervals or unevenness, which may cause the gap at the contact part, can be absorbed by preparing such a heat conductive component in the contact part, to secure the thermal conductivity.

The outer fin 5 is an offset fin, and the offset fins positioned adjacent to each other in the direction F1 are offset with a predetermined distance in a direction perpendicular to the direction F1. The outer fin 5 has plural wave parts in which the wave advancing direction corresponds to the flowing direction F2 of the low-temperature fluid, and the wave overlapping direction corresponds to the flowing direction F1 of the high-temperature fluid.

Accordingly, the high-temperature fluid easily flows between the waves, and the outer fin 5 can raise the rigidity in the flowing direction F1 of the high-temperature fluid. As a result, the rigidity of the first holding member 3 and the second holding member 4 to which the outer fin 5 is joined can also be raised in the flowing direction F1. The first holding member 3 and the second holding member 4 have the joint part 3a and the joint part 4a, respectively, at the both ends in the flowing direction F1, and the joint part 3a and the joint part 4a are welded with each other. A stress which forces the power generation module 1 and the heat conductive component 6 onto the pipe 7 is generated by welding the joint part 3a and the joint part 4a. The rigidity over this stress can be raised by the outer fin 5, such that the tightness between the components can be secured.

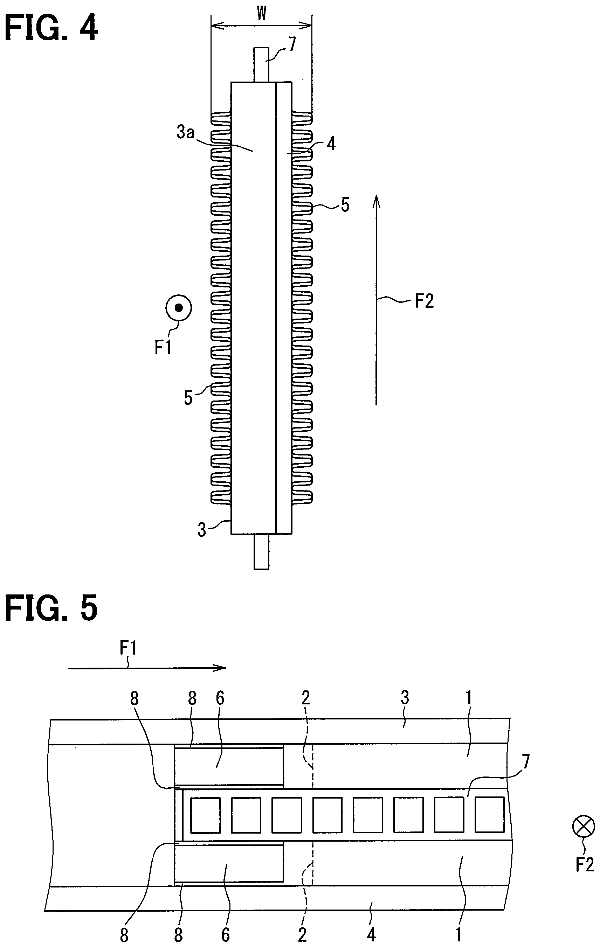

The first holding member 3 and the second holding member 4 in the joined state are set to have length in the flowing direction F1, in a range, for example, between 130 mm and 200 mm. The pipe 7 supported between the first holding member 3 and the second holding member 4, and the outer fin 5 are set to have length in the flowing direction F1, in a range, for example, between 85 mm and 155 mm. The pipe 7 is set to have length of, for example, about 160 mm in the flowing direction F2. The thermoelectric power generator 100 is set to have a length W in the stacking direction, which is shown in FIG. 4, for example, of about 35 mm between the tip ends of the outer fins 5.

The first holding member 3 and the second holding member 4 are pressed in the directions shown by blank arrows of FIG. 1, at an assembling time, to increase the overlap between the joint part 3a and the joint part 4a. In this pressed state, the joint part 3a and the joint part 4a are welded with each other by seam welding or laser welding.

Thereby, the first holding member 3 and the second holding member 4 produce the stress supporting both sides of the power generation module 1. Furthermore, the power generation module 1 and the heat conductive component 6 are in tight contact with both the holding member 3, 4 and the pipe 7. This pressurizing power acts between the pipe 7 and the power generation module 1, and between the power generation module 1 and the holding member 3, 4, to define the contact part between the components. Moreover, the pressurizing power acts between the pipe 7 and the heat conductive component 6 and between the heat conductive component 6 and the holding member 3, 4, to define the contact part between the components.

The joint part 3a and the joint part 4a are welded by seam welding or laser welding to form a weld part extended along the flowing direction of the low-temperature fluid. Accordingly, the joint part 3a and the joint part 4a can be welded firmly. Furthermore, the weld part may be formed on a tip surface 3b of the joint part 3a.

The thermoelectric power generator 100 configures a stacking object in which the outer fin 5, the first holding member 3, the power generation module 1 and the heat conductive component 6, the pipe 7, the power generation module 1 and the heat conductive component 6, the second holding member 4, and the outer fin 5 are stacked in this order from the upper side to the lower side in FIG. 1. For example, the low-temperature fluid flows in the direction perpendicular to the flow of the high-temperature fluid, as shown in FIG. 2 - FIG. 4. The rigidity of the outer fin 5 is low in the wave extending direction such that the outer fin 5 is easily expanded and contracted in the wave extending direction. The rigidity of the outer fin 5 is high in a direction perpendicular to the wave extending direction, such that the outer fin 5 is difficult to expand and contract in this perpendicular direction.

A bending stress is applied to the first holding member 3 and the second holding member 4 due to the pressurizing force in the direction shown by the blank arrows of FIG. 1. For this reason, it is desirable to have a rigidity that can withstand the bending stress. Therefore, the outer fin 5 is set to raise the rigidity in the flowing direction F1 of the high-temperature fluid, and to lower the rigidity in the perpendicular direction perpendicular to the direction F1.

The first holding member 3 and the second holding member 4 are elastically deformed by being bent on the outer side of the end of the power generation module 1. For this reason, the tight contact is securable among the power generation module 1, the heat conductive component 6, the first holding member 3, the second holding member 4, and the pipe 7 by the reaction force of the first holding member 3 and the second holding member 4 trying to return to the original position due to the elastic deformation, while maintaining the contact part at the end of the power generation module 1.

As shown in FIG. 5, it is desirable to interpose a grease or a graphite sheet which has thermal conductivity, as a thermal connection component 8, between the heat conductive component 6 and the pipe 7, between the heat conductive component 6 and the first holding member 3, and between the heat conductive component 6 and the second holding member 4. The thermal resistance between the components can be reduced by the thermal connection component 8, to realize efficient heat transfer between the high-temperature fluid and the low-temperature fluid through the heat conductive component 6.

The graphite sheet has very high thermal conductivity. For example, the graphite sheet may have more than twice of the thermal conductivity of copper or aluminum. The graphite sheet is thin and flexible, and is easy to deform and processing. The graphite sheet may be manufactured by thermally cracking a high polymer film. It is desirable that the graphite sheet has high degree of orientation close to a single crystal structure.

Moreover, it is desirable that hardness of the thermal connection component 8 is low such that it is easily deformed by external force, than the heat conductive component 6, the pipe 7, the first holding member 3, and the second holding member 4. Since the thermal connection component 8 can be deformed according to expansion and contraction of each component, the heat conductive component 6 can be easily displaced relative to the pipe 7, the first holding member 3, and the second holding member 4. Therefore, if each component expands and contracts by a difference in temperature caused by the high-temperature fluid and the low-temperature fluid, since the heat conductive component 6 is easily displaced, a stress caused by distortion of each component is effectively reduced, and a thermal expansion difference between components is effectively absorbed.

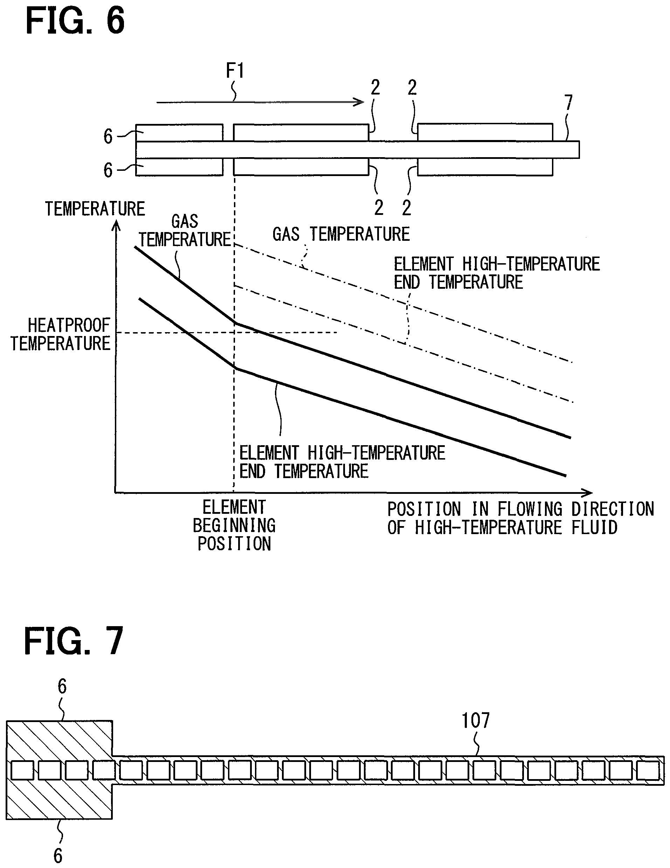

Next, a relation between a position inside the thermoelectric power generator 100 in the flow direction of the high-temperature fluid and the temperature is explained, with reference to FIG. 6. In the thermoelectric power generator 100, heat transfer between the high-temperature fluid and the low-temperature fluid is facilitated through the heat conductive component 6 at the upstream of the thermoelectric conversion element 2 of the power generation module 1 in the flow of high-temperature fluid. Thereby, the heat of the high-temperature fluid flowing into the first passage is transferred to the low-temperature fluid through the heat conductive component 6 and the pipe 7 first. Thus, heat dissipation through the heat conductive component 6 is facilitated before the high-temperature fluid exchanges heat with the thermoelectric conversion element 2 on the downstream side, such that the temperature of the high-temperature fluid can be reduced.

As shown by a solid line in FIG. 6, in the range from the upstream end of the heat conductive component 6 to the upstream end of the thermoelectric conversion element 2, the temperature of the high-temperature fluid and the temperature of the high-temperature end of the element are lowered with a large change ratio, since heat dissipation through the heat conductive component 6 is performed actively, compared with the downstream region of the heat conductive component 6. That is, the temperature decreasing rate of the high-temperature fluid or the high-temperature end of the element is large in the range from the upstream end of the heat conductive component 6 to the upstream end of the thermoelectric conversion element 2 than in the range from the upstream end of the thermoelectric conversion element 2 to the downstream end.

In FIG. 6, a single chain line represents temperatures of a high-temperature fluid and a high-temperature end of the element in a thermoelectric power generator which does not have a heat conductive component at the upstream side. The temperatures fall as flowing to the downstream. In this thermoelectric power generator, heat transfer from the high-temperature fluid to the low-temperature fluid will be performed through a power generation module from the upstream end. In case where the high-temperature fluid flows into the first passage with a temperature exceeding the heat-resistant temperature of the element, the temperature of the high-temperature fluid and the temperature of the element at the high-temperature end may be higher than the case of the thermoelectric power generator 100, in a rage from the upstream end to the downstream end of the power generation module. In this case, the temperatures may exceed the heat-resistant temperature of the element.

According to the thermoelectric power generator 100, the heat transfer is facilitated by the heat conductive component 6, such that the temperature of the high-temperature fluid and the temperature of the element at the high-temperature end can be lowered, before the heat of the high-temperature fluid transfers to the power generation module 1. If the element temperature is over the heat-resistant temperature when heat is transferred through the heat conductive component 6, the element temperature can be controlled to become less than the heat-resistant temperature, at the beginning position of the thermoelectric conversion element 2, i.e., in the downstream region than the upstream end.

Next, the advantages achieved by the thermoelectric power generator 100 of the first embodiment are explained. The thermoelectric power generator 100 includes the pipe 7 in which the first fluid flows, the power generation module 1 including the thermoelectric conversion element 2, and the holding member that is in direct or indirect contact with one side part of the power generation module so that the heat of the second fluid, that is higher in temperature than the first fluid, transfers to the one side part of the power generation module. The holding member holds the power generation module 1 and the pipe 7 in the state where heat can transfer so that the pipe 7 is in direct or indirect contact with the other side part of the power generation module 1. Furthermore, the thermoelectric power generator 100 includes the heat conductive component 6 which has thermal conductivity and interposed between the holding member and the pipe 7 to define the heat transfer course through which heat transfers to the first fluid from the second fluid. The heat conductive component 6 is supported between the holding member and the pipe 7 at the upstream of the thermoelectric conversion element 2 in the flowing direction of the second fluid.

According to the thermoelectric power generator 100, the heat conductive component 6 defines the heat transfer course at the upstream of the power generation module 1 in the flow of second fluid. Therefore, heat of the second fluid can be transferred to the pipe 7 through the heat conductive component 6 before the heat of the second fluid transfers to the power generation module 1 through the holding member. That is, the heat recovery to the first fluid is increased at the upstream side in the flow of second fluid, and the temperature of the second fluid can be lowered not to cause deterioration in the components. Thereby, the temperature of the second fluid can be lowered when heat is transferred from the second fluid to the power generation module 1, compared with a case where the heat of the second fluid is transferred to the power generation module 1 at the most upstream in the heat transfer course from the second fluid to the first fluid. The thermoelectric conversion element 2 can be restricted from having the temperature causing thermal deterioration, by lowering the temperature of the second fluid.

On the other hand, the heat of the second fluid can be collected to the first fluid through the heat conductive component 6 at the upstream side. Thereby, the heat recovery performance can be secured, without wasting the heat of the second fluid vainly. Moreover, the power generation performance can be secured by securing a difference in temperature between the one side part and the other side part of the power generation module 1, if the amount of heat collection through the heat conductive component 6 at the upstream side is set up properly. As mentioned above, both of the heat recovery performance and the power generation performance of the thermoelectric power generator 100 can be better, and the thermal deterioration of the thermoelectric conversion element 2 can be restricted.

Moreover, since it is not necessary to have a valve mechanism which switches a channel, like the conventional technology, in the thermoelectric power generator 100, the number of components, e.g., for controlling the operation, can be reduced, such that the size and the weight can be reduced.

The thermoelectric power generator 100 offers the holding force holding the stacked object in which the heat conductive component 6, the power generation module 1, and the pipe 7 are stacked. Specifically, the stacked object is formed by stacking, relative to the pipe 7, the heat conductive component 6 and the power generation module 1 in this order in the flowing direction F1 of the second fluid on the one side of the pipe 7, and by stacking the heat conductive component 6 and the power generation module 1 in this order in the direction F1 on the other side of the pipe 7. That is, the plural power generation modules 1 hold the pipe 7 by the holding force by the first holding member 3 and the second holding member 4. The plural heat conductive components 6 hold the pipe 7 by the holding force by the first holding member 3 and the second holding member 4.

According to the thermoelectric power generator 100, heat can be collected from the second fluid on both sides of the pipe 7 in which the first fluid flows, and the power generation by the power generation module 1 can be carried out. Therefore, the thermoelectric power generator 100 can be provided to achieve both of the efficient power generation and the efficient heat collection, in which the thermoelectric conversion element 2 can be thermally protected for the high performance and the long life proof.

### (Second embodiment)

A second embodiment is described with reference to FIG. 7. A configuration having the same reference numeral as the first embodiment in FIG. 7 is the same as that of the first embodiment. The configuration, processing, action, and effect not particularly explained in the second embodiment are the same as the first embodiment. Hereafter, only points different from the first embodiment are explained.

A pipe 107 of the second embodiment is different from the pipe 7 of the first embodiment in that the heat conductive component 6 is integrally formed with the pipe 107. The pipe 107 integrally includes the heat conductive component 6 projected from the respective sides of the pipe 107 at the upstream end in the flowing direction F1. The heat conductive component 6 in the pipe 107 is located upstream of the power generation module 1 in the flow of high-temperature fluid in the state where the power generation module 1 is in the tight contact with the respective sides of the pipe 107. The pipe 107 may be formed, for example, by extrusion molding.

Since the heat conductive component 6 and the pipe 107 are integrally formed as one component, according to the second embodiment, the heat resistance can be reduced in the heat transfer course from the high-temperature fluid to the low-temperature fluid. Therefore, since the heat collection performance through the heat conductive component 6 can be improved, the temperature of the thermoelectric conversion element 2 can be restricted from exceeding the heat-resistant temperature, to suppress thermal deterioration of the thermoelectric conversion elements 2.

### (Third embodiment)

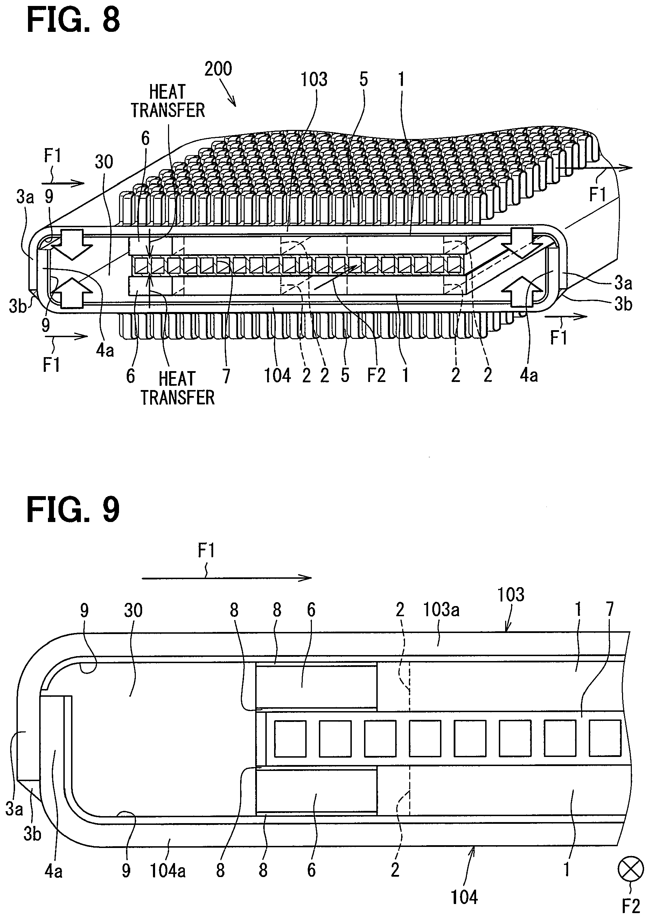

A thermoelectric power generator 200 according to a third embodiment is explained with reference to FIG. 8 and FIG. 9. A configuration having the same reference numeral as the first and second embodiments is the same as that of the first and second embodiments. The configuration, processing, action, and effect not particularly explained in the third embodiment are the same as the first and second embodiments. Hereafter, only points different from the first and second embodiment are explained.

As shown in the drawings, a first holding member 103 and a second holding member 104 are respectively different from the first holding member 3 and the second holding member 4, and have stacking configuration in which the materials are different.

The first holding member 103 is made of a cladding material including a base material 103a and a high thermal conductivity material 9 with thermal conductivity higher than the base material 103a. The high thermal conductivity material 9 is joined to the surface of the base material 103a in contact with the one side part of the power generation module 1 and to the surface of the base material 103a in contact with the heat conductive component 6. The cladding material is formed by joining one predetermined metal layer surface and another metal layer surface with applying pressure, and rolling. The cladding material is also called as a clad metal. Since the metals are joined between atoms by pressure, the surfaces of the metals do not easily exfoliate, even if not using adhesives.

The first holding member 103 includes plural layers made of different materials, e.g., the base material 103a and the high thermal conductivity material 9. The high thermal conductivity material 9 of the first holding member 103 contacts the heat conductive component 6 directly, or contacts the heat conductive component 6 indirectly through the thermal connection component 8, to be in contact with the power generation module 1. The heat of the high-temperature fluid transfers to the base material 103a directly or through the outer fin 5, and transfers to the high thermal conductivity material 9 from the base material 103a. Further, the heat is transferred to the heat conductive component 6 or the power generation module 1 through the high thermal conductivity material 9. The heat transfer speed of the high-temperature fluid, which flows outside of the first holding member 103, toward the downstream in the flowing direction F1 is different between in the state where the heat is transmitted to the base material 103a and in the state where the heat is transmitted to the high thermal conductivity material 9. In other words, the heat transmitted to the base material 103a is easily transferred to the high thermal conductivity material 9 from the base material 103a, compared with the heat transmitted inside of the base material 103a to the downstream side. The heat transmitted to the high thermal conductivity material 9 tends to transfer inside of the high thermal conductivity material 9 to the downstream side more quickly than the heat which transfers inside of the base material 103a to the downstream side. Thereby, the first holding member 103 has characteristics in which the heat of the high-temperature fluid transmitted to the upstream side of the first holding member 103 is easily transferred to the heat conductive component 6 or the power generation module 1 on the downstream side due to the high thermal conductivity material 9 at a position near the one side part of the power generation module 1.

The second holding member 104 is formed of a cladding material including the base material 104a and the high thermal conductivity material 9 with thermal conductivity higher than the base material 104a. The high thermal conductivity material 9 is joined to the surface of the base material 104a in contact with the one side part of the power generation module 1 and the surface of the base material 104a in contact with the heat conductive component 6. The second holding member 104 includes plural layers made of different materials, e.g., the base material 104a and the high thermal conductivity material 9. The high thermal conductivity material 9 of the second holding member 104 is in direct contact with the heat conductive component 6, or contacts the heat conductive component 6 indirectly through the thermal connection component 8, so as to be in contact with the power generation module 1. The heat of the high-temperature fluid transfers to the base material 104a directly or through the outer fin 5, transfers to the high thermal conductivity material 9 from the base material 104a, and transfers to the heat conductive component 6 or the power generation module 1 through the high thermal conductivity material 9. The heat transfer speed of the high-temperature fluid, which flows outside of the second holding member 104, to the downstream side in the flowing direction F1 is different between in the state where the heat is transmitted to the base material 104a and in the state where the heat is transmitted to the high thermal conductivity material 9. In other words, the heat transmitted to the base material 104a is easily transferred to the high thermal conductivity material 9 from the base material 104a than moving inside of the base material 104a to the downstream side. The heat transmitted to the high thermal conductivity material 9 tends to transfer inside of the high thermal conductivity material 9 to the downstream side more quickly than the heat which transfers inside of the base material 104a to the downstream side. Thereby, the second holding member 104 has characteristics in which the heat of the high-temperature fluid transmitted to the upstream side of the second holding member 104 is easily transferred to the heat conductive component 6 and the power generation module 1 on the downstream side by the high thermal conductivity material 9 at a position near the other side part of the power generation module 1.

For example, the base material 103a and the base material 104a are made of stainless steel material, and the high thermal conductivity material 9 is made of copper material. The high thermal conductivity material 9 is not provided on the joint part 3a of the first holding member 103. Accordingly, the joint part 3a and the joint part 4a can be joined with each other between the same material, since the base material 103a and the base material 104a are made of the same material, to avoid a junction between different materials. The first holding member 103 may be formed by not covering the joint part 3a with the high thermal conductivity material 9 in advance, or the first holding member 103 may be formed by removing the high thermal conductivity material 9 from the joint part 3a after covering with the high thermal conductivity material 9.

According to the third embodiment, the thermoelectric power generator 200 has the first holding member 103 and the second holding member 104 formed by covering the base material 103a and the base material 104a with the material with high thermal conductivity than the base material 103a and the base material 104a on the surface in direct or indirect contact with the one side part of the power generation module 1 and the heat conductive component 6. Accordingly, the high thermal conductivity material 9 facilitates the heat transfer at the upstream side of the high-temperature fluid, to the downstream side. Thereby, since the temperature of the holding member can be lowered on the upstream side of the high-temperature fluid, the thermal stress can be reduced to restrict the aged deterioration of the holding member.

Each of the first holding member 103 and the second holding member 104 is made of the cladding material including the base material and the high thermal conductivity material 9 having thermal conductivity higher than the base material and joined to the surface in direct or indirect contact with the one side part of the power generation module 1 and the heat conductive component 6. Accordingly, the holding member which achieves the above-described effects can be manufactured by rolling with pressurizing and joining the predetermined different material layers to improve the productivity of the thermoelectric power generator 200.

### (Other embodiment)

The disclosure in this description is not restricted to the illustrated embodiment. The disclosure includes the illustrated embodiments and modifications by a person skilled in the art based on the illustrated embodiments. For example, disclosure is not limited to the component and/or the combination of the components shown in the embodiments. The disclosure can be carried out with various combinations. The disclosure may use additional parts which can be added to the embodiments. The disclosure may contain modifications in which component and/or element of the embodiments are removed. The disclosure may contain modifications in which component and/or element of the embodiments are exchanged or combined. Technical scope of disclosure is not limited to the embodiments. It should be understood that some disclosed technical scope may be shown by description in the scope of claim, and contain all modifications which are equivalent to and within description of the scope of claim.

The thermoelectric power generator 100 is broadly applicable also to an apparatus not for a vehicle. For example, the thermoelectric power generator 100 may be combined with waste heat recovery equipment using gas emitted from a boiler for industry or residences as the high-temperature fluid. The thermoelectric power generator 100 is applicable to a portable dynamo, an electric power unit of an electric apparatus, or a dynamo using exhaust heat exhausted from a factory or an incinerator as the high-temperature fluid.

The thermoelectric power generator 100 is not limited to the configuration illustrated in FIG. 1. For example, the thermoelectric power generator 100 may be formed by integrally holding a stacked object by the holding member, in which the heat conductive component 6 and the power generation module 1 arranged in this order in the flowing direction F1 of the second fluid on the one side of the pipe 7 is stacked on the pipe 7. That is, the thermoelectric power generator 100 may have the heat conductive component 6 and the power generation module 1 integrally holding the pipe 7 on only one side of the pipe 7.

The thermoelectric power generator 100 provides one power generation unit in the above embodiment. Alternatively, the thermoelectric power generator 100 may provide plural power generation units stacked with each other. Also in this case, the high-temperature fluid flows in contact with the outer fin 5 located between the power generation units.

The heat conductive component 6 of the first embodiment is not fixed to the pipe 7, the first holding member 3, and the second holding member 4 individually. However, the heat conductive component 6 may be fixed to the first holding member 3 or the second holding member 4 adjacent to the high-temperature fluid, or the pipe 7 adjacent to the low-temperature fluid. The heat conductive component 6 of the second embodiment is integrally formed with the pipe 7, as an example being fixed to the component adjacent to the low-temperature fluid.

The first holding member 3 is smaller than the second holding member 4, and the first holding member 3 is fitted into the second holding member 4 in the embodiment. The first holding member 3 and the second holding member 4 may have the same size, and may be combined with each other as offset.

In the embodiment, the first holding member 3 and the second holding member 4 are welded, and the interior space 30 surrounded by the first holding member 3 and the second holding member 4 is sealed from the outside. However, the first holding member 3 and the second holding member 4 may be not completely sealed, to such an extent that the high-temperature fluid does not have a bad influence on the power generation module 1 in the interior space 30. For example, the first holding member 3 and the second holding member 4 may be combined by spot welding at plural points.

The power generation module 1 of the embodiment may not be covered by a case. The P type semiconductor devices and N type semiconductor devices may be exposed from the interior space 30 surrounded by the first holding member 3 and the second holding member 4. In the thermoelectric power generator 100, a case is not an indispensable component. In this case, it is desirable to seal the interior space 30 with a cover.

The bonded surfaces of the joint part 3a of the first holding member 3 and the joint part 4a of the second holding member 4 are flat in the embodiment. The bonded surfaces may have a concavo-convex form engaged with each other such as saw blade projection or labyrinth form.

In the embodiment, the first holding member 3 and the second holding member 4 are in contact with the power generation module 1 through a planer surface. Alternatively, the first holding member 3 and the second holding member 4 may be in contact with the power generation module 1 through a curved surface. An object excellent in heat conduction, such as a graphite sheet or a thermally conductive grease, may be interposed between the first holding member 3 and the second holding member 4, and the power generation module 1. Moreover, the thickness of the graphite sheet may not be uniform.

In the embodiment, the upstream ends of the pipe 7 and the heat conductive component 6 in the flow of high-temperature fluid may be aligned with each other or located offset from each other.

In the embodiment, the flat pipe 7 which forms the second passage includes plural passages inside, but is not limited to such a form. The pipe 7 may not have the flat shape, and fins may be arranged in the pipe 7.

In the embodiment, the first holding member 3 and the outer fin 5 may be formed integrally as one unit, and the second holding member 4 and the outer fin 5 may be formed integrally as one unit.

In the embodiment, the low-temperature fluid and the high-temperature fluid may form opposite flows flowing reversely from each other.

## Claims

1. A thermoelectric power generator comprising:
a pipe (7) in which a first fluid flows;
a power generation module (1) including a thermoelectric conversion element (2);
a holding member (3, 4; 103, 104) that holds the power generation module and the pipe in a heat transferable state, the holding member being in direct or indirect contact with a one side part of the power generation module, such that heat of a second fluid that is higher in temperature than the first fluid transfers to the one side part of the power generation module, the pipe being in direct or indirect contact with the other side part of the power generation module; and
a heat conductive component (6) that is thermally conductive to define a heat transfer course between the holding member and the pipe, through which heat transfers from the second fluid to the first fluid, wherein
the heat conductive component is interposed between the holding member and the pipe, at an upstream side of the thermoelectric conversion element in a flowing direction of the second fluid.

2. The thermoelectric power generator according to claim 1, wherein
the holding member includes a first holding member (3; 103) and a second holding member (4; 104), and
the first holding member and the second holding member define a holding power holding a stacking object in which the heat conductive component and the power generation module arranged in the flowing direction of the second fluid at one side of the pipe, the pipe, and the heat conductive component and the power generation module arranged in the flowing direction of the second fluid at the other side of the pipe are stacked with each other.

3. The thermoelectric power generator according to claim 1 or claim 2, wherein
the holding member (103, 104) has a covering material having a thermal conductivity that is higher than that of a base material (103a, 104a) of the holding member, the covering material covering a surface of the base material in direct or indirect contact with the one side part of the power generation module and a surface of the base material in direct or indirect contact with the heat conductive component.

4. The thermoelectric power generator according to claim 3, wherein
the holding member is made of a cladding material having the base material and a high conductivity material (9), wherein a thermal conductivity of the high conductivity material is higher than that of the base material, and the high conductivity material is joined to the surface of the base material in direct or indirect contact with the one side part of the power generation module and the heat conductive component.

5. The thermoelectric power generator according to any one of claims 1-4, the heat conductive component is in contact with the holding member through a graphite sheet.

6. The thermoelectric power generator according to any one of claims 1-4, wherein the heat conductive component is in contact with the holding member through a grease which is thermally conductive.

7. The thermoelectric power generator according to any one of claims 1-4, wherein the heat conductive component is in contact with the holding member and the pipe through a graphite sheet.

8. The thermoelectric power generator according to any one of claims 1-6, wherein the heat conductive component and the pipe are integrally formed with each other as one component.
